# EUROPEAN PATENT APPLICATION

(11) **EP 0 631 300 A2**
(43) Date of publication of application: **28.12.1994**
(21) Application number: 94304440.4
(22) Date of filing: 20.06.1994
(51) Int. Cl.: H01L 21/225, H01L 31/18, H01L 31/105

(54) **Selective diffusion for III - V semiconductor devices**

(30) Priority: 23.06.1993 JP 177233/93
(71) Applicant: SUMITOMO ELECTRIC INDUSTRIES, LIMITED, Osaka 541 (JP)
(72) Inventor: Tanaka, Nobuhisa, c/o Osaka Works of, Konohana-ku, Osaka (JP); Iwasaki, Takashi, c/o Osaka Works of, Konohana-ku, Osaka (JP); Yoneyama, Shun-Ichi, c/o Osaka Works of, Konohana-ku, Osaka (JP); Iguchi, Yasuhiro, c/o Osaka Works of, Konohana-ku, Osaka (JP)
(74) Representative: Smith, Norman Ian

(57) **Abstract**

Closed tube methods have been employed to diffuse impurities selectively in a groups III - V semiconductor wafer. The closed tube methods are convenient for preventing the element of group V from dissociating out of the wafer surface by pressurizing the vapor pressure of the element of group V. Open tube methods failed in diffusing impurities without defects due to the fluctuation of the vapor pressure of the element of group V. Both methods have relied upon the vapor phase diffusion using a gas containing impurities. This invention adopts an open tube method of diffusing impurities in solid phase. This invention forms a suppression mask film having windows selectively on a wafer, and grows impurity-containing films on the windows by vapor phase reaction in an open reaction tube. The impurities diffuse from the impurity-containing films to the wafer substrate in solid phase. The impurity diffusion occurs either at the same time of the growth of the films or after the growth of the films at a different temperature. The compound semiconductor is covered with solid films during the impurity diffusion. This invention is immune from the difficulty of escape of elements of group V from the surface of a wafer.

## Description

This application claims the priority of Japanese Patent Application No.177233/1993 filed June 23, 1993, which is incorporated herein by reference.

This invention relates to a method of producing group III - V semiconductor devices, in particular, to a method of impurity diffusion. III - V semiconductor means GaAs, GaP, InP, InSb, etc. Impurity diffusion is a treatment introducing impurity atoms via a surface into a semiconductor by some excitation, for example, by heat, in order to convert the electronic conduction type of the semiconductor. P-type impurities or n-type impurities are converted into a gas and introduced into a semiconductor via the surface. Many kinds of p-type impurities and n-type impurities for III - V semiconductors are known . For example, a p-type region is made by diffusing zinc (Zn) in III - V semiconductors.

Epitaxial growth can also form semiconductor layers including impurity atoms on a substrate. However, epitaxial growth makes a flat film including impurity atoms uniformly. The impurity diffusion can dope a once-grown crystal with impurity atoms and can dope the impurity in any arbitrary patterns on a crystal by lithography. The doping of impurity atoms by thermal diffusion has been well known in the technology of silicon semiconductor devices. In the case of silicon semiconductor, an SiO₂ film is used as an insulating, passivation film. This invention aims at an improvement of impurity diffusion not of Si but of III - V semiconductors. Besides the problem of the passivation film, III - V semiconductors have difficulties different from silicon.

The object crystals in which impurities shall be doped are various types of crystals, for example, a wafer of InP, GaAS or GaP, or a film epitaxially grown on a wafer or on another film. The object crystal is now called a substrate in short. Thus the substrate on which impurities shall be diffused includes films besides a wafer. Selective diffusion means that impurities are doped only into restricted regions but not doped into other regions. Since the regions of impurity diffusion are previously determined in the face of the substrate, the diffusion is called "selective".

Many textbooks on semiconductor explain about methods of selective impurity diffusion into a semiconductor crystal on fabrication. For example, "INTRODUCTION OF RECENT SEMICONDUCTORS", SEIBUNDOSHINKOSHA p.54-p.58 explains the prior methods of selective impurity diffusion. Impurities are diffused into an object crystal from vapor-phase, liquid-phase or solid-phase. For example, when phosphor (P) is doped into silicon (Si), the material is one of red phosphor(P), P₂O₅, POCl₃, PBr₃, PH₃ and so forth. At room temperature, red phosphor and P₂O₅ are solid, POCl₃ and PBr₃ are liquid and PH₃ is gas. In any cases, the material shall be vaporized, because the impurity material is stored in a vessel separated from the vessel containing the substrate.

In the case of solid material, the material is vaporized by heating and is transported by a carrier gas. In the case of liquid material, the material is stored into a bubbler and is vaporized by bubbling with the carrier gas and is transported by the carrier gas. In the case of gas material, it can be simply transported by a carrier gas.

The technology of selective impurity diffusion has already matured for silicon wafers. The selective diffusion employs phosphor (P) as an impurity for producing an n-type region and boron (B) as an impurity for making a p-type region. The regions which should not be doped are covered with an insulating film of SiO₂, which plays the role of a mask on the substrate. Then the gas including impurities is introduced on the masked substrate. The impurity atoms contact with the uncovered parts of the surface and diffuse into the uncovered surface. The impurity diffusion is classified into two categories from the standpoint of apparatus. One is a closed tube method, and the other is an open tube method. The open tube method lays a semiconductor substrate (wafer) in a tube having both ends open, heats the substrate (wafer), introduces a material gas from one opening end, and exhausts the gas from the other opening end. The open tube method can control the flux and the impurity ratio of the material gas. The closed tube method lays a semiconductor wafer (substrate) in a quartz or glass tube having an end, makes the tube vacuous, fills the tube with a material gas having impurities, closes the end by melting the end by a flame of a gas burner. The closed tube method cannot change the ratio of impurity of the gas, because the gas is sealed in the closed tube. The apparatus for replenishing a material of impurity is contingent upon the state of the impurity, i.e. solid material, liquid material or vapor material. In general, the open tube method is suitable for the impurity diffusion of silicon devices.

The method of impurity diffusion in III - V semiconductors is explained, for example, by M. WADA, M. SEKO, K. SAKAKIBARA & Y. SEKIGUCHI, "Zn Diffusion into InP Using Dimethylzinc as a Zn Source", Jpn. J. Appl. Phys. vol.28, L1700-1703(1989).

The paper proposed a method having the steps of placing an InP wafer(substrate) in a horizontal furnace, replenishing a material gas of 4.6 slm comprising 200 sccm of DMZ (dimethylzinc) diluted to 1500 ppm by Helium (He)), 200 sccm of PH₃ and the rest of carrier gas (H₂:50vol% + N₂:50vol%), and letting zinc diffuse into the InP wafer at a pressure of 76 Torr at a substrate(wafer) temperature of 400 °C to 570 °C. The time of diffusion is 0.5 hour to 2 hours. Unlike the silicon diffusion, the diffusion of III - V semiconductors requires a means for preventing group V elements from dissolving from the surface of crystals, because group V elements have a high dissolving pressure at a high temperature. Thus PH₃ gas, a gas of an element of group V, is supplied into the furnace for suppressing the dissociation of phosphor (P) out of the surface of the crystal. This belongs to the category of the open tube methods.

The close tube method is a diffusion method comprising the steps of storing a semiconductor substrate and an impurity material in a quartz tube with a closed end and an open end, making the tube vacuous from the open end, sealing the open end, heating the closed tube in a furnace, and diffusing impurities into the substrate. Since the tube is sealed, the inner space is kept to be quasi-equilibrium and fully immune from a turbulent flow. Of course the closed tube method may be available for silicon semiconductor devices. In practice, the closed tube method has, however, scarcely been used for silicon.

On the contrary, III - V semiconductor devices have always been produced by the closed tube method. In this case, a substrate (wafer), a source of impurity and a solid of the element of group V of the periodic table are stored into a quartz tube. The group V element is sealed in the tube for suppressing the group V element from dissolving from the surface of the substrate. The closed method is a suitable and convenient method for diffusing impurities into a small substrate experimentally.

Japanese Patent Publication No.2-24369(24369/'90) proposed an improvement of diffusion of zinc (Zn) into an InP crystal by a closed tube method. ZnP₂ was employed as an impurity source. A substrate and an impurity source ZnP₂ were stored and sealed in a quartz tube. Then ZnP₂ was locally heated. ZnP₂ was dissolved into vapor of Zn₃P₂ + P. The vapor of Zn₃P₂ + P was condensed on an inner surface of the quartz tube. Zn was diffused into the InP crystal by heat. Zinc (Zn) as a dopant and phosphor (P) for controlling the pressure of the element of group V were supplied as a compound of Zn and P. The method dispensed with replenishing a Zn source and a P source individually. Furthermore, the method facilitated the control of pressure in the closed tube.

The diffusion of the closed tube method puts a semiconductor wafer, a source of an element of group V and a source of a dopant (impurity) in a quartz tube, seals the tube, heats the closed tube in a furnace, and diffuses the dopant (impurity) into the substrate. The closed tube method cools the quartz ample after the diffusion. Then the diffused region is likely to be polluted by the impurity or the components of the element of group V. When the quartz ample is broken, fragments of the ample adhere to the surface of the crystal. The elimination of the broken pieces requires an extra process and extra time.

The open tube method lays a crystal wafer(substrate) in an open reaction tube (e.g. quartz), heats the substrate, replenishes the substrate with a gas including the element of group V and impurities, and diffuses the impurities into the substrate directly from the vapor phase. In the meantime, a turbulent flow is liable to occur in the reaction tube. The turbulent flow causes the instability of the pressure and the ratio of components in the gas. The decline of the partial pressure of group V gas in the gas flow induces the dissociation of group V gas from the surface of the wafer. The dissolution of group V gas deteriorates the crystallographical property of the surface of diffusion region of the substrate. Furthermore, during the process of the diffusion, the substrate is exposed to the gas. Dust or contaminant in the gas is likely to adhere to the substrate.

Besides the drawbacks on fabrication, the conventional diffusion methods suffer from another drawback on inspection. Since the prior method diffuses impurity atoms from vapor phase, it is difficult to estimate the quality of the diffusion. Optical observation on the whole wafer is unable to estimate the quality of the impurity diffusion. The abnormality of impurity diffusion is not detected, before the wafer is divided into many device chips, the chips are mounted on packages into devices, and the devices are inspected by applying electric currents. Electrical inspections can determine for the first time whether the devices are good or bad. The bad devices which have been disqualified in the electrical examinations will be abandoned with the packages. Thus all the materials, processes, and packages come to nothing with regard to the rejected articles. It is desirable to discover the failure of impurity diffusion in the wafer process before being separated into chips. If the defects of diffusion can be detected at the early stage of fabrication, the following processes can be omitted for the disqualified chips by eliminating them out of the processes.

To achieve the foregoing objects and in accordance with the purpose of the invention, embodiments will be broadly described herein.

The diffusion method of this invention comprises the steps of growing an impurity-containing film doped with high concentration of impurities selectively on the substrate, diffusing impurity atoms from the growing impurity-containing film to the substrate by heat during the crystal growth of the impurity-containing film, cooling the substrate, and eliminating the impurity-containing film selectively from the substrate till the diffusion region appears on the substrate. The impurity diffusion synchronizes with the impurity-containing film.

Namely, the diffusion of this invention is a new method relying upon a selective film growth and a selective etching. Conventional methods of impurity diffusion have made use of the diffusion from vapor phase. Unlike conventional methods, this invention utilizes the diffusion from solid phase. Solid phase diffusion features this invention clearly. Since the impurity-containing films are once grown selectively on the substrate for the solid phase diffusion of impurity, the material gas includes not only an impurity-containing gas, a group V element gas and a carrier gas but also a material gas for the formation of the impurity-containing films. Since the substrate is covered with the impurity-containing films during the diffusion, no dusts nor contaminant adhere to the surface of the substrate. The covering of substrate with the impurity-containing film prevents the group V element gas from subliming out of the surface of the substrate. The material of the impurity-containing films should be different from the material of the substrate, because the impurity-containing films shall be selectively etched away from the substrate.

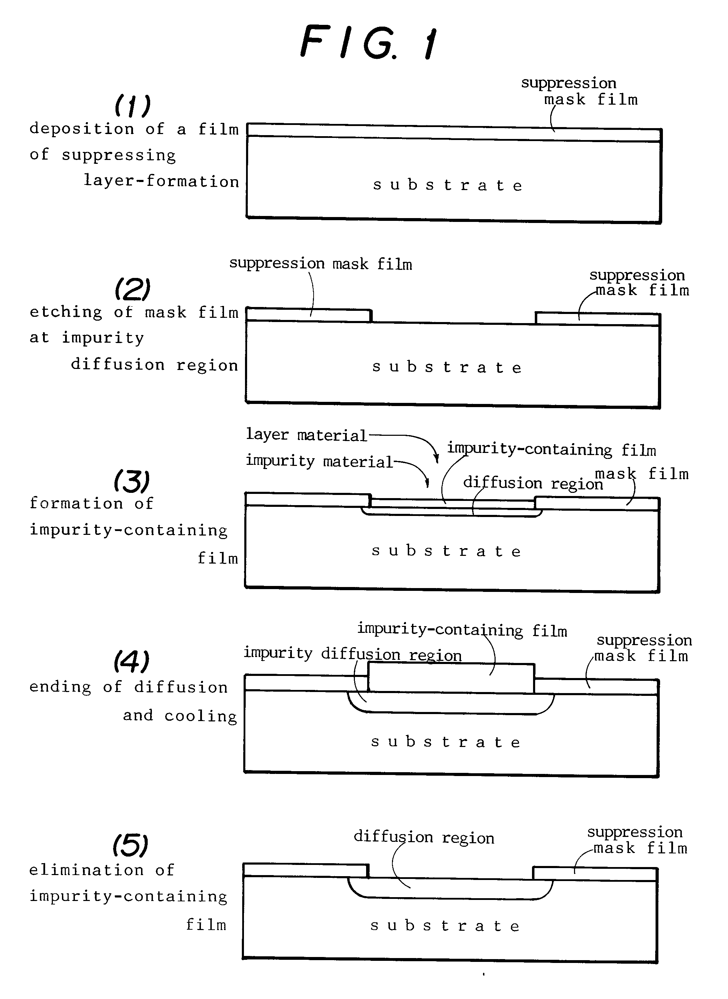

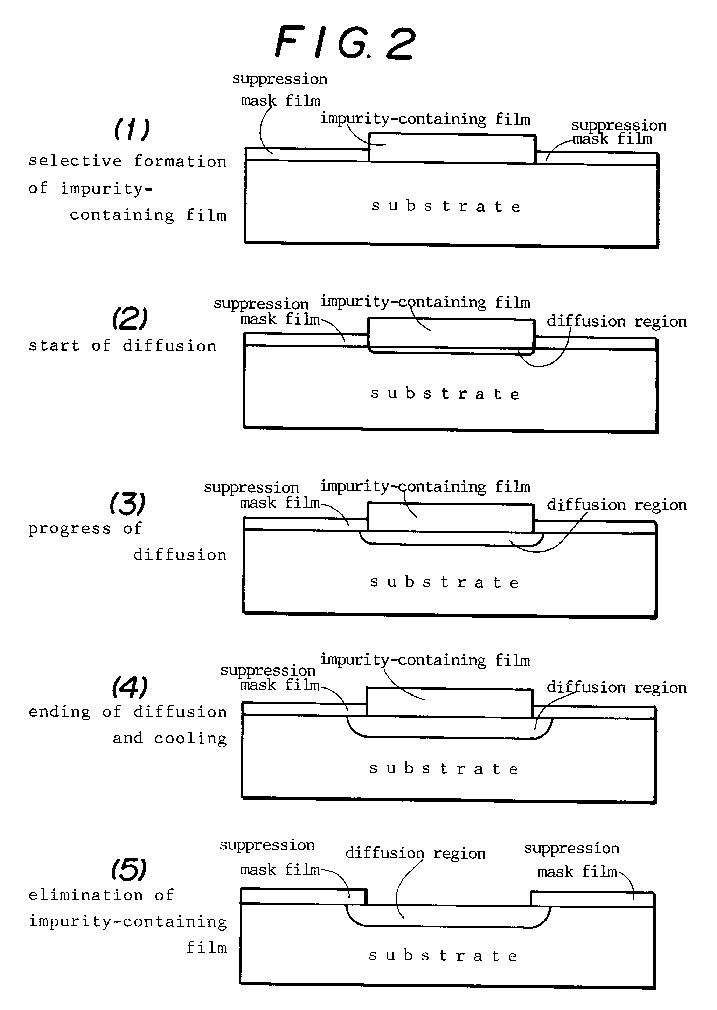

The method of this invention will now be explained by Fig.1 and Fig.2. A substrate in the figures widely means a crystal on which impurity atoms shall be doped. The substrate implies not only a III - V element wafer but wafers on which epitaxial layers or an epitaxial layer with electrodes are fabricated. The substrate should be called "an object crystal to be doped with impurities", but is named in brief a "substrate".

Fig.1 shows the processes of the impurity diffusion. In (1) of Fig.1 a suppression mask film is deposited on a substrate by evaporation, sputtering or CVD method. Any materials are available for the suppression mask film, if they can prohibit the formation of films which will be deposited in the following processes. Then the parts of the suppression film on which impurity atoms will be doped are eliminated by photolithography, as shown in (2) of Fig. 1. The parts of the substrate are exposed through windows of the suppressive film. Prior methods used to diffuse impurity atoms on the windows in vapor phase by and supplying an impurity-containing gas.

This invention does not employ vapor phase diffusion of impurity. Otherwise, this invention grows impurity-containing films on the windows. The impurity-containing film means a crystal which differs from the substrate crystal and includes impurity atoms of a high concentration. The impurity-containing films are formed by supplying the material gas of the film and the impurity (dopant) simultaneously on the substrate in vapor phase. The pertinent method of the formation of the impurity-containing film depends upon the material of the film, for example, evaporation, sputtering, CVD and so forth. (3) of Fig.1 shows the process in which the impurity-containing film is growing gradually. The impurity-containing film includes impurity atoms of a high concentration. Furthermore, the substrate has been heated at a high temperature. Impurities diffuse from the impurity-containing film to the substrate across the solid-solid interface. The diffusion from a solid is now called " solid phase diffusion ". "phase" means the state of the source of impurities. This invention features party the impurity diffusion from a solid (solid phase diffusion) and party the synchronization of the crystal growth of the impurity-containing film with the diffusion of the impurity atoms. (4) of Fig. 1 demonstrates the finish of the growth of the impurity-containing film. The impurity diffusion, however, still continues on the same condition or on another condition at a different temperature. The impurity atoms diffuse from the impurity-containing film surface into the substrate. The diffusion region is increasing in the substrate. The depth of the diffusion region can be controlled by the time of diffusion. When the diffusion has finished, the substrate is cooled in the same state. The window is still covered with the impurity-containing film. Thus contaminant never comes into contact with the substrate in the cooling process. The surface of the substrate is not polluted by any components in the gas in the reaction chamber, because the impurity-containing film protects the substrate in the process.

When the substrate is cooled to room temperature or a certain low temperature, the impurity-containing films are eliminated by selective etching from the windows as shown in (5) of Fig.1. Diffusion regions appear. No impurity is included in the regions below the suppression film. Fig.1 shows the processes in which the impurity diffusion is simultaneous with the formation of the impurity-containing films. The temperature for the impurity diffusion is equal to the temperature of the film formation. The time of the impurity diffusion is also equal to that of the film formation.

However, some impurities or some substrates require different optimum temperatures for the formation of the film and for the impurity diffusion. Otherwise, the appropriate time of the two processes may be different. Some impurity demands a short time for forming a film and a long time for diffusing impurity atoms. When the optimum time or optimum temperature for the film formation is different from the optimum time or optimum temperature for the impurity diffusion, two processes must proceed at different temperatures at different times.

In such a case, the film formation must precede the impurity diffusion, as shown in Fig.2. (1) of Fig.2 shows the sample after the processes of depositing a suppression mask film, forming windows at central spots of devices by photolithography and selectively forming impurity-containing films on the windows. In the processes, little impurity diffusion occurs because of the temperature lower than the optimum temperature for diffusion. Then the substrate is heated up to the optimum temperature for impurity diffusion. Then impurity atoms begin to diffuse from the film into the substrate, as shown in (2) of Fig.2. This is a solid phase diffusion of impurity. The part near the surface which has impurities of higher concentration than the substrate is called now "a diffusion region". The diffusion region is increasing with time. (3) of Fig.2 exhibits an intermediate state of the sample having a moderate thickness of the diffusion region. Then the impurity diffusion is completed. The impurities reach the appropriated depth in the substrate, as shown in (4) of Fig.2. Then the sample is cooled to a pertinent temperature. The impurity-containing films are removed from the windows. The impurity diffusion regions appear at the windows ( (5) of Fig.2).

The advantages of the invention are now explained. This invention comprises the steps of growing impurity-containing films selectively on openings of suppression mask film on a wafer, and diffusing impurities from the impurity-containing films to the uncovered parts (openings) of the substrate (wafer) across the solid-solid interface (in solid phase). This method has the following advantages superior to prior methods.
① This invention produces a suppression mask film on a wafer having epitaxial films, perforates windows on the mask film by photolithography, forms impurity-including films on the windows, and diffuses impurities from the film into the epitaxial layers across the film-layer boundary. During the impurity diffusion, the windows of the substrate are covered with the impurity-concluding films. The surface is protected by the suppression mask film and the impurity-containing films. The element of group V does not escape from the surface of the substrate, even if the pressure of the element of group V in the reaction tube is not controlled. The stoichiometry can be maintained during the impurity diffusion by the impurity-containing films.
② This invention covers the substrate with a suppression mask film having windows, deposits impurity-containing films on the windows (openings), and diffuses impurity atoms from the films to the epitaxial layers. The wafer is cooled in the state where the surface of the substrate is still protected by the impurity-containing films. The surface of the substrate is kept clean during the cooling process. No contaminant pollutes the surface of the wafer in cooling as well as in diffusing.
③ This invention diffuses impurities by forming impurity-containing films on the openings. The chemical reaction for growing the impurity-containing films is controlled by the temperature of the wafer (substrate) and is immune from the fluctuation of the components of the material gases. The control of the substrate temperature enables the impurity-containing films to grow at a stable ratio of components. The stability of the component of the films is transcribed to the impurity distribution in the substrate. Thus the impurity concentration is constant in the whole surface in the openings(windows) of the substrate. When the same processes are repeated for a plurality of wafers, the same distribution of impurity is easily accomplished to all the wafers. The stability of the impurity concentration enables a maker to produce the wafers having an arbitrary concentration of impurity.
④ Conventionally the closed tube methods have been adopted for the impurity diffusion of group III - V compound semiconductor. Unlike the conventional methods, this invention employs an open tube method for the impurity diffusion. Thus this invention can be applied to large size wafers. This is one of excellent advantages of the open tube methods. Conventional closed tube methods are incapable of treating with wide wafers because of the restricted section of closed tubes. The applicability to large size wafers greatly decreases the cost of production. For example, this invention can still be employed to diffuse impurity atoms for a III - V semiconductor wafer of a 2 inch diameter.
⑤ The following advantage is more radical. This invention covers the surface of the wafer with the impurity-containing films during the impurity diffusion. The covering by the impurity-containing films prevents the element of group V from dissolving out of the surface. Dissociation of the element of group V from surfaces of crystals at a high temperature has been a common inconvenience of groups III - V semiconductors. This invention enables more reliable diffusion than the conventional methods. The reliable diffusion means the probability of the uniformity of diffusion and the facile controllability of the depth of diffusion.

Unlike silicon, the groups III - V semiconductors have been annoyed by the common drawback that the vapor pressure of the element of group V is high at a high temperature. The atoms of group V are likely to escape from the surfaces of substrate crystals or film crystals. The escape of the element of group V is the common difficulty for groups III - V semiconductors.

Silicon semiconductor is entirely immune from this problem. The impurity diffusion in silicon is ruled by the factors such as temperature, time and diffusion coefficient. In the case of groups III - V semiconductors, the impurity diffusion is also contingent upon the vacancies of group V atoms in addition to temperature, time and diffusion coefficient. The element of group V (P, As, etc.) is likely to evaporate in vapor phase at a high temperature. Therefore, the closed tube method stores a solid P source or a solid As source in a sealed tube. Then the partial pressure of the element of group V is maintained at a sufficient level in order to forbid the element of group V from escaping out of the crystal by controlling the temperature of the solid source of the group V element. The reason why the conventional diffusion has relied upon the closed tube methods is the easiness of the pressure control of the element of group V.

The open tube method hinders the element of group V from escaping out of the surface of the crystal by letting a gas including the element of group V flow in the tube and by enhancing the partial pressure of the group V element. However, the dissociation of the element of group V cannot fully be prevented owing to the fluctuation of the components in the gas or the fluctuation of the pressure. Even if vacancies of the element of group V are apparently not found by the optical microscope observation, there must be still vacancies of the element of group V somewhere on the crystal surface. The vacancies of the element of group V have a great influence upon the impurity diffusion. Even when the other conditions are the same, the distribution and the depth of the impurity diffusion are greatly influenced by the distribution of the vacancies of group V element. The escape of the group V element from a crystal surface is always a serious problem in the case of vapor phase diffusion of impurity.

However, this invention first covers the surfaces of the openings with the impurity-containing films. During the diffusion, no element of group V dissolves from the surface of the III - V crystal regardless of the vapor pressure of the element V, because the surface is protected by the impurity-containing films.
⑥ The diffusion coefficient in solid phase is smaller than the diffusion coefficient in vapor phase. Such a small diffusion coefficient favors this invention with the uniformity of diffusion and the precise control of diffusion depth.
⑦ This invention has another merit of a precise estimation of the result of diffusion. Prior methods have examined only the properties of the final state, e.g. the diffusion depth or the carrier density. On the contrary, this invention can estimate the diffusion property by the state of an intermediate process. This invention makes the impurity-containing films in the intermediate state which persists in the diffusion process. The impurity-containing films are also useful for the inspection or the examination of the processes. The films can be examined by the X-ray diffraction or by the photoluminescence (PL) without breaking the films. The inspection of the impurity-containing films allows an indirect verification of the controlled impurity diffusion. When some disorder occurs, the ground of the disorder can be searched by analyzing the intermediate impurity-containing films. The existence of the impurity-containing films brings about advantages of stabilizing the diffusion process and facilitating the analysis of malfunctions.
⑧ This invention enables to examine the quality of the diffusion in the wafer process. In general, fabrication of semiconductor devices requires the steps of formation of insulating films, production of electrodes, diffusion of impurity and so forth. Since the insulating films and the electrodes can easily be observed by microscopes, the optical observation of the shapes or appearance allows us to estimate the quality of the insulating films or the electrodes. However, such an optical observation is quite useless for inspecting the quality of the impurity diffusion, because diffusion does not change the appearance of the object.

When a disorder of impurity diffusion induces something wrong of semiconductor devices, the observation of an appearance cannot determine the ground of the defect. The quality of the diffusion process is examined for the first time at the final step where individual chips scribed from a wafer are mounted on packages, the electrodes are wirebonded with the leads and electric currents are applied to the devices. The irregularity of diffusion invites various defects. In some cases, the insulating film (e.g. SiN film) acting as a mask of diffusion has sometimes small holes (defects) or partially peels away from the wafer at peripheries. Such defects of the suppression mask film invite uncontrollable diffusion which degrades the quality of semiconductor devices. Optical observation cannot detect the abnormality of the diffusion due to the defects of the insulating films.

On the contrary, this invention enables the optical observation to examine the quality of diffusion. In this invention, when the insulating mask film has holes, porosities or peelings, impurity-containing crystal granules grow abnormally at the defects. The insulating suppression mask films suppress the deposition of the impurity-containing films. At the holes, porosities or peelings, the suppression films are partially absent. Thus impurity-containing granules grow abnormally at the defects. The crystals induced by defects are extraordinary big. The observation through an optical microscope can find out the defect-induced crystals. Therefore, this invention observes the wafer by an automatic microscope after the steps of growing the impurity-containing films, diffusing the impurities into the substrate and cooling the wafer. The automatic microscope observes the wafer, receives the image of the whole wafer in the image memory, recognizes the images by individual devices by the image-processing and compares the images of the individual devices with a standard device image stored in the image memory. If the object device has any impurity-containing films in addition to the films of the standard device, the object device must have had some defects of the insulating, suppressing mask film, and extra impurity-containing crystals must have grown at the defects. Such devices with the extra impurity-containing crystals shall be rejected. The rejected devices are memorized by the numbers assigned to the device units by the location on the wafer. Then the impurity-containing films are eliminated, and the wafer is scribed into a plenty of individual chips. From the separated chips, the device chips which have judged as rejected articles are removed at the stage by identifying the number memorized at the step of the image processing. Namely, this invention enables the discovery of rejected devices at a step of the wafer process by the microscope observation.
⑨ This invention simplifies the process of inspection or selection of devices. In the fabrication of semiconductor devices, the wafer processes produce a plenty of devices from a wafer in one stroke. However the inspection of semiconductor devices has been done to individual chips mounted on packages by applying an electric current actually. The inspection follows the entire wafer process. A device shall be estimated in consideration of many characteristics. The characteristics which are contingent upon the quality of crystals (epitaxial layers and substrate) vary continually on a wafer as a function of locations. Continual change of quality signifies that the defects are liable to flock together. Integral, overall observation on a wafer is in particular advantageous for discovering the collective defects.

The properties which cannot be examined by the observation of appearance of the wafer have to be estimated by separating chips from the wafer, mounting each chip on a package and connecting pads of the device with leads of the package. The individual inspection demands a package on which the chip is fixed. If the device turns out to be defective one by the final inspection, the whole device shall be abandoned. The package without default is also thrown away with the chip, because the package cannot remove from the chip. The result of the inspection sometimes forces a manufacturer to waste the package cost and the cost of mounting the chip on the package.

Furthermore, it takes a long time to examine all devices one by one. Integral examination in a lump is more desirable than the individual inspection. It is more convenient to check the devices still existing on one wafer by some method than to estimate the individual devices fixed on the packages by applying currents actually. Such an integral inspection will curtail the time and packages.

This invention enables an operator to examine the properties of all devices on a wafer by observing the irregular growth of the impurity-containing crystals on the defects of the insulating suppression mask films. The whole, overall examination finds out defective devices on the wafer. The bad devices are memorized by the address number on the wafer. When the wafer is scribed into many chips, the bad devices are removed and abandoned. The defective device chips are not mounted on packages. The packages are saved. The time of inspection is curtailed also. This invention succeeds in alleviating the cost of inspection of the devices by finding the bad devices in the wafer process.

The invention will be more fully understood from the following description given by way of example only with reference to the several figures of the accompanying drawings in which ;

Fig.1 is sectional views of a sample in the processes of the impurity diffusion in the case of the simultaneous film formation and impurity diffusion of this invention.

Fig.2 is sectional views of a sample in the processes of the impurity diffusion after the film formation on the windows in the case of the film formation preceding the impurity diffusion.

Fig.3 is a partially sectioned perspective view of an example of a photodetector.

Fig.4 is sectional views of a sample in the former processes on fabrication of the device of Fig.3.

Fig.5 is sectional views of a sample in the latter processes on fabrication of the device of Fig.3.

Fig.6 is a sectioned view of a sample after the processes of depositing an SiN film (suppression mask film) on an InP substrate, making windows on the SiN film, and growing Zn-doped InGaAs films (impurity-containing film) on the revealed surface of the InP substrate at the windows.

Fig.7 is a sectioned view of the sample after the processes of diffusing Zn, and etching away the Zn-doped film from the substrate.

Fig.8 is a simplified sectional view of the horizontal vapor phase reactor for growing Zn-doped InGaAs films on an InP substrate.

Fig.9 is a graph showing the relation between the depth from the film surface and the Zn-concentration of the impurity-containing film and the substrate after depositing Zn-doped InGaAs films on the substrate and diffusing Zn atoms into the substrate.

Fig. 10 is a graph showing the relation between the depth from the surface of the substrate and the Zn-concentration on the substrate after depositing Zn-doped InGaAs films on the substrate, diffusing Zn-atoms into the substrate and eliminating the InGaAs film from the window.

This invention will be clarified by explaining an embodiment of diffusing Zn atoms selectively on an n-type InP substrate. The Zn-diffusion is employed in order to fabricate photodetectors of InP types. The substrate is an n-type InP doped with silicon (Si). This invention is employed for converting parts of the n-type substrate into p-type regions by p-type impurity (dopant) diffusion. Zn, Mg and Cd are p-type dopants (impurity) for InP. This invention can be applied to any dopant of them. This invention is now explained by giving the case of the dopant of Zn as an embodiment. In the specification, the word "dopant" is used as a synonym of "impurity".

This invention grows Zn-doped InGaAs films selectively on windows of a mask on an n-type InP substrate, diffuses Zn atoms from the Zn-doped InGaAs film into the substrate by the solid phase diffusion, and makes p-type regions at the windows on the substrate by the following processes. The invention can be adopted as parts of the processes for fabricating photodetectors.

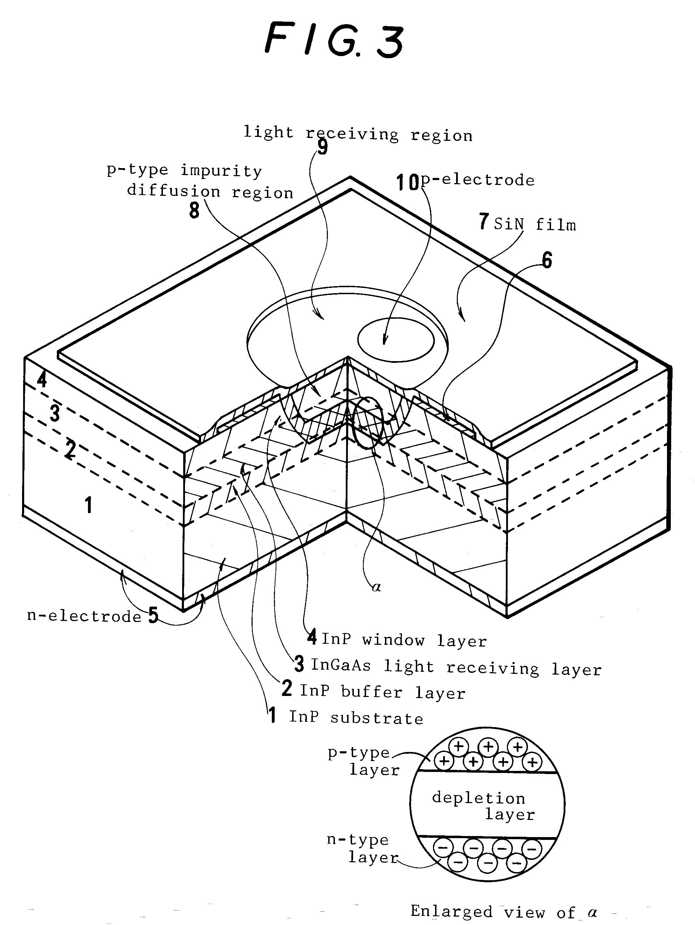

The fundamental structure of a well-known photodetector is now explained by Fig.3. The substrate (1) is an n-type InP single crystal. An InP buffer layer (2), an InGaAs light receiving layer (3) and an InP window layer (4) are epitaxially grown on the n-type InP substrate (1) in succession. An n-(side) electrode (5) is formed on the bottom surface of the InP substrate (1). Suppression mask layers with windows (openings) are selectively formed on the InP window layer (4) by evaporation or CVD and photolithography. Zinc (Zn), p-type dopant (impurity) is selectively diffused down by heat through the openings of the suppression mask layer into the InP window layer (4) and InGaAs light receiving layer (3). A diffusion region is formed at a central part of each device. At the central part, a p-type region, an i-type region and an n-type portion are successively produced. The part α is enlarged and depicted below Fig.3. The enlarged view shows the first p-type layer doped with Zn, the second depletion layer and the third n-type crystal. A pin junction is formed at the central region. The peripheral part is covered with an SiN film (7). The central part of the surface without the SiN film is a light receiving region (9). A p-(side) electrode (10) is deposited on a part of the light receiving region (9). A voltage will be reversely applied between the n-electrode (5) and the p-electrode (10), when the device is used as a photodetector.

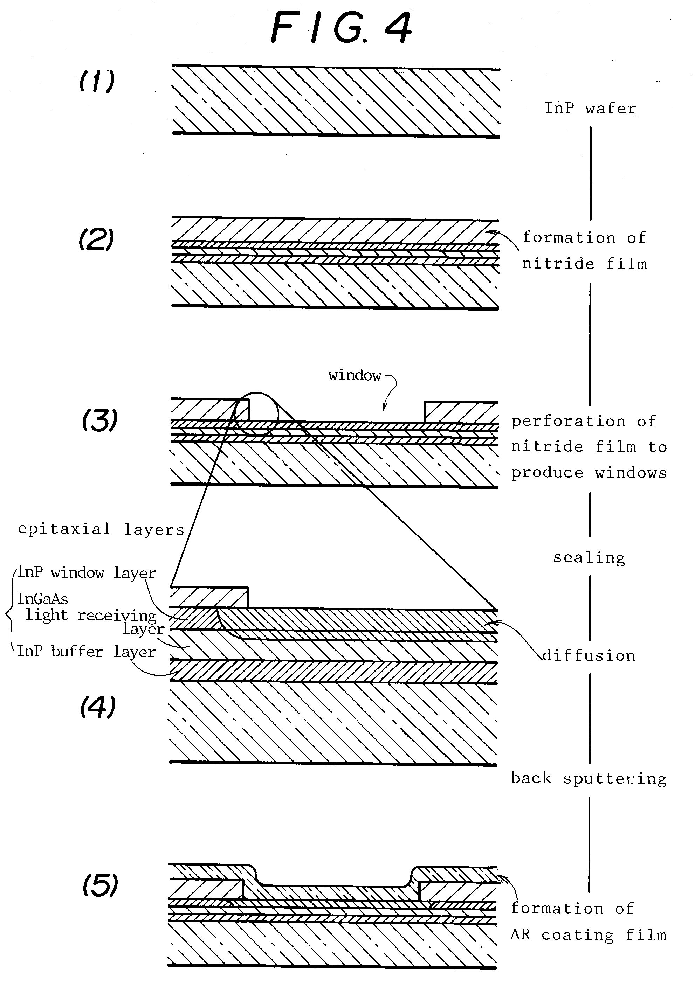

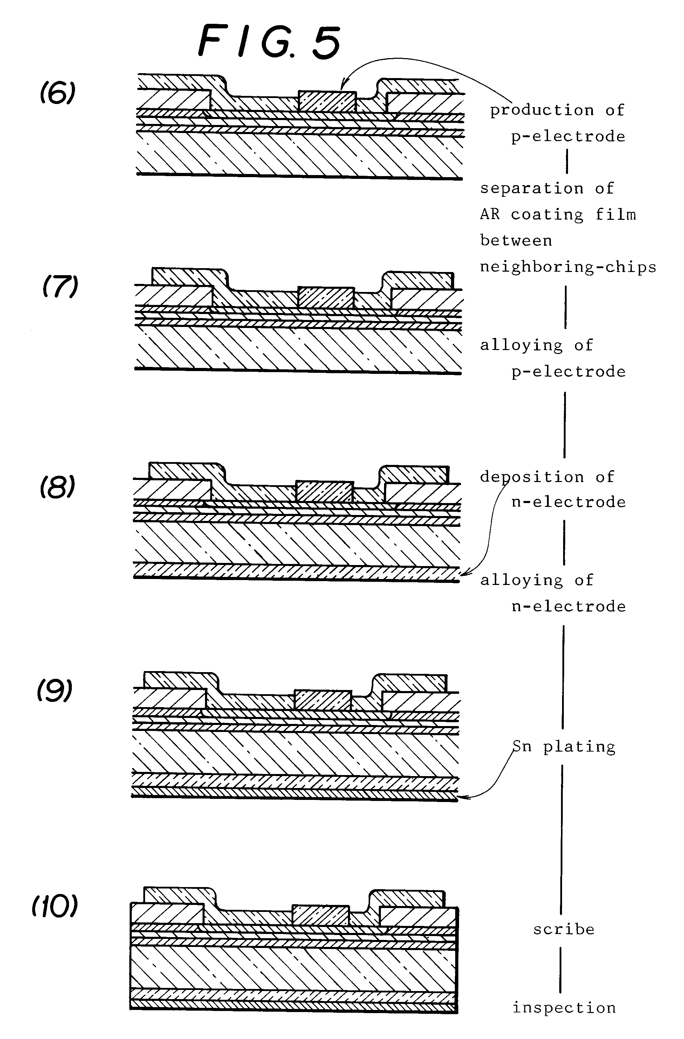

Fig.4 and Fig.5 demonstrate the well-known fabrication processes of the photodetectors in succession. (1) of Fig.4 shows a starting InP monocrystal substrate (wafer). Although these figures show sectional views of a single device, a plenty of equivalent devices are being fabricated at the same time on a single wafer by the wafer processes. As mentioned before, an InP buffer layer, an InGaAs light receiving layer and an InP window layer are epitaxially grown on the InP substrate in succession. Further, an SiN (Si₃N₄: silicon nitride) film is deposited on the InP window layer, as shown by (2) of Fig.4. Then portions of the nitride film (SiN) are eliminated and windows for diffusion are perforated. (3) of Fig.4 shows this state. Zinc (Zn) is diffused through the windows into the epitaxial layer. (4) of Fig.4 shows an enlarged view of the edge of the window after the diffusion. The diffusion develops to the middle of the InGaAs light receiving region below the opening (window).

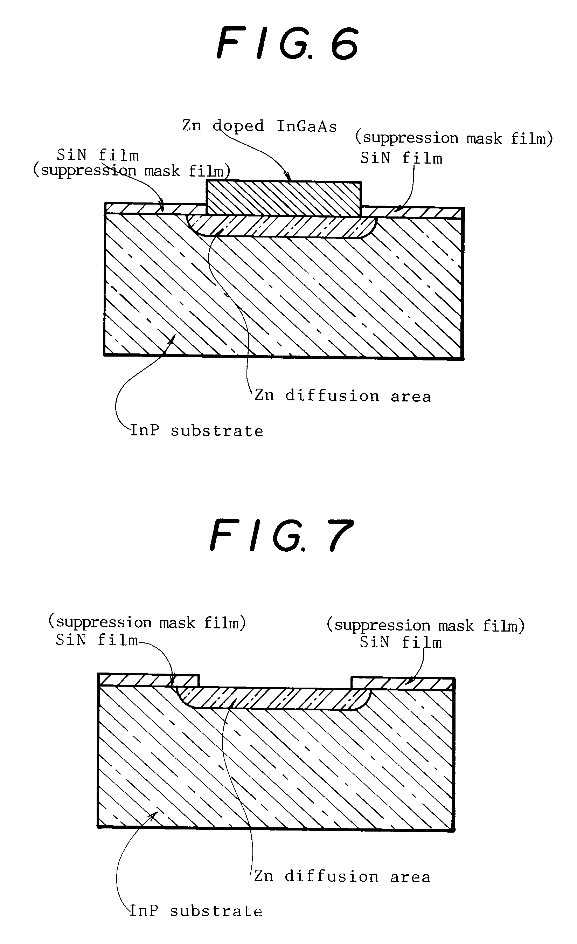

Conventional method used to diffuse Zn in vapor phase. However, this invention diffused the p-dopant in solid phase as shown in Fig. 6 and Fig.7. The solid phase diffusion characterizes this invention. When the impurity diffusion has ended, the impurity-containing film is eliminated by the back-sputtering. An antireflection (AR) coating film is formed on the whole wafer, as shown in (5) of Fig.4.

A part of the AR coating film is removed, and a p-side electrode is deposited on the revealed part of the light receiving region ((6) of Fig.5). The p-electrode is in contact with the p-type dopant diffusion region. The AR coating film is separated for all devices by cutting the coating film along bisectors between neighboring devices. The p-electrode and a part of the p-type InP layer are alloyed by heating in order to ensure the ohmic contact of the p-electrode with the p-type region of InP. (7) of Fig.5 shows the state of a device in the wafer. An n-(side) electrode is produced on the bottom surface of the InP substrate, as shown in (8) of Fig.5. The n-electrode is also alloyed with the InP substrate by heating at a suitable temperature. Tin (Sn) is plated on the bottom surface of the n-electrode. All the above processes are wafer processes. Then the wafer is scribed into individual chips at cleavage lines ((10) of Fig.5). A plenty of chips are obtained from a single wafer. Every chip will be stored into a package and inspected individually. The individual chips will be stores in packages. The processes of Fig.4 and Fig.5 are common, ordinary steps for the fabrication of photodetectors.

This invention differs at the dopant diffusion process from the ordinary, conventional method of fabrication. The impurity diffusion of (4) of Fig.4 is accomplished by the solid phase diffusion, as shown in Fig.6 and Fig.7.

First, windows are selectively perforated at the centers of devices on the SiN film. Zn-doped InGaAs films (impurity-containing film) are grown on the openings (windows) by supplying a material gas including Zn, In, Ga, As, etc. The SiN film has a property preventing InGaAs from depositing on it. SiN suppresses the crystal growth of InGaAs. Thus the InGaAs films grow only on the surface of the substrate appearing at the openings. The InGaAs deposited on the windows is a film containing high concentration of Zn. The highly-doped InGaAs films jam the openings.

The wafer is heated and kept for a proper time at a suitable temperature. Zn diffuses in solid phase from the Zn-doped InGaAs films into the nearest InP window layer and the second-nearest InGaAs receiving layer. Since the impurity diffuses in solids, the speed of diffusion is slow. The slow speed may be a drawback. However, the distribution of the dopants becomes uniform in the whole area of the opening (window), because the concentration of the dopant in the InGaAs source film is uniform. Furthermore, since the openings are covered with and protected by the InGaAs film during the dopant diffusion, the surface of the substrate is not polluted by contaminant or dust. The surface of the substrate is kept clean while the impurity diffuses in the substrate.

Besides the uniform distribution and the clean surface, this invention is favored with the convenience of discovering defects. If the SiN film has unintentionally-borne holes at the parts except the openings due to imperfect deposition, the InP substrate partially appears from the holes. InGaAs will also grow at the holes. Such an abnormal growth on the holes can be detected by the microscope observation. Thus the defects of the diffusion process can be found out at an early stage of production. The early detection of defects is also an advantage of this invention.

When the impurity diffusion is ended, the wafer is cooled. The wafer is examined by a microscope. The Zn-doped InGaAs is eliminated from the InP wafer. Then the wafer will be treated along the following processes from (5) of Fig.4 to (10) of Fig.5.

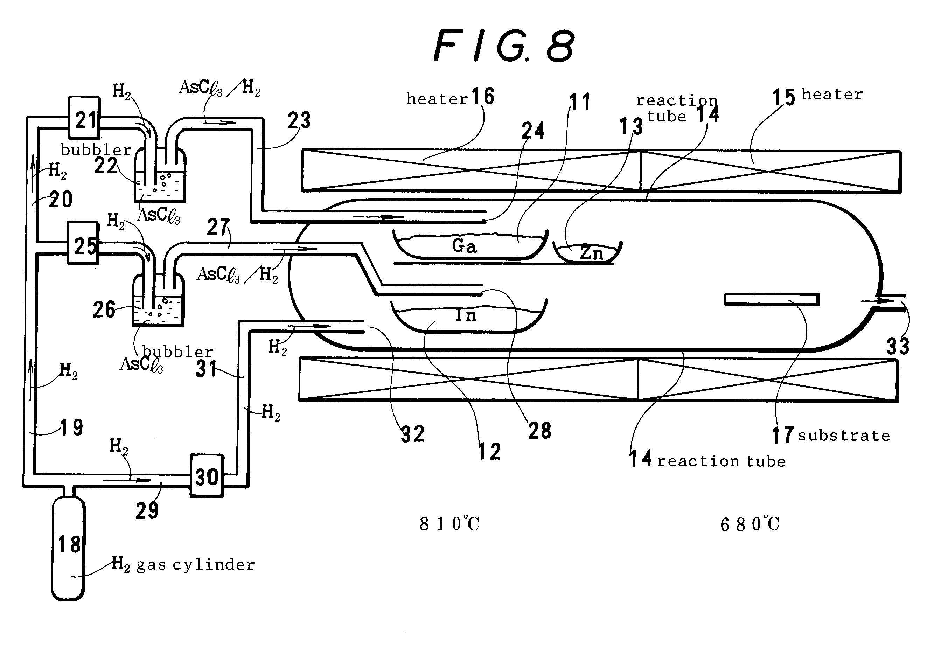

Fig.8 is a sectional view of the reaction apparatus for diffusing impurity by the method of this invention. A Ga source boat (11), an In source boat (12) and a Zn source (13) are installed in a reaction tube (14). The reaction tube is a horizontal reaction chamber having two heaters (15) and (16) in series in the axial direction. A hydrogen gas cylinder (18) is prepared outside the reactor for replenishing hydrogen gas of high purity to the reactor (14). Bubblers (22) and (26) contain liquid AsCl₃ for providing the reactor (14) with AsCl₃. The bubblers give arsenic to the reactor (14) in the form of chloride. Hydrogen gas is supplied to the bubblers (22) and (26) for letting the liquid AsCl₃ bubble. Hydrogen gas is introduced as a carrier gas into the bubblers (22) and (26). The bubblers (22) and (26) are kept at room temperature or another constant temperature by some devices (not shown). Since the element of group V is supplied as a chloride, the method of the embodiment is called a chloride VPE method. The chloride method is superior in safety to other vapor phase methods, for example, MOCVD and hydride VPE.

Otherwise, hydrides AsH₃ and PH₃ are also employed in order to supply the element of group V in gas phase. The MOCVD and hydride VPE produce compound semiconductors of groups III - V from a material gas containing hydride of arsenic (As) or phosphor (P). The MOCVD and hydride VPE are distinguished by the difference of the ways for introducing the element of group V. This invention can be also applied to the impurity diffusion in the MOCVD method or the hydride VPE method.

The functions of the apparatus will be explained. The Ga source boat (11) in the reaction tube contains Ga metal. The In source boat (12) stores In metal. The Zn source (13) is positioned in the vicinity of the Ga source boat (11). The source boats (11) and (12) and the Zn source (13) are laid at the front half part of the reaction tube (14). The wafer (17) consists of the InP substrate, the InP buffer layer, the InGaAs light receiving layer, the InP window layer and the silicon nitride film with windows which have been already formed by the preceding processes of epitaxial growth and photolithography. The wafer (17) is laid at the rear half of the reaction tube (14). This example adopts an SiN as a suppression mask film and an InGaAs film as an impurity-containing film. During the reaction, the region of the wafer is kept at a temperature of 680 °C and the region of the source boats are maintained at a temperature of 810 °C, for example. The temperature of the regions can be arbitrarily adjusted by the power of the heaters (15) and (16).

The hydrogen cylinder (18) replenishes highly pure hydrogen gas H₂. Hydrogen gas H₂ passes through a conduit (19) and mass flow controllers (21) and (25) and enters the liquid AsCl₃ in the bubblers (22) and (26). The hydrogen gas plays the role of a carrier gas which lets the liquid AsCl₃ bubble, and transports the mixed gas of AsCl₃/H₂ to the reaction tube (14). One mixed gas AsCl₃/H₂ produced in the bubbler (22) goes through a conduit (23) and enters the reaction tube (14) out of an opening end (24) of the conduit (23) which is positioned in the vicinity of the Ga source boat (12) and the Zn source(13). The source region is kept at a higher temperature (e.g. 810 °C ), some parts of Ga and Zn are vaporized in the hot front half region. Since the mixed gas AsCl₃/H₂ is introduced into the vapor of Ga and Zn, vapor phase reactions take place at the regions among Ga vapor, Zn vapor, AsCl₃ and H₂.

On the other hand, the other bubbler (26) produces another mixture vapor of AsCl₃ and H₂. The AsCl₃/H₂ gas goes through a conduit (27) and reaches a region above the In source boat (12) in the reaction tube (14). The vapor phase reaction makes chloride of Ga above the Ga source boat (11) and chloride of In above the In source boat (12). Furthermore, hydrogen gas supplied from the hydrogen cylinder (18) flows in the other conduit (29) and passes through a mass flow controller (30). Then the hydrogen gas goes through a conduit (31) and enters the forefront (32) of the reaction tube (18). The flows of the AsCl₃/H₂ gas and H₂ gas can be precisely controlled by the mass flow controllers (21), (25) and (30).

Chlorides InCl and GaCl produced at the source boats (11) and (12), and zinc (Zn) are transported by the carrier gas to the wafer (substrate) (17). The wafer (17) is partially covered with a silicon nitride (SiN) film. InP appears partially at the holes of the SiN film. InGaAs synthesized by the vapor phase reaction deposits at the revealed surface of the InP crystal epitaxially. Since high concentration of Zn is included in the vapor, the InGaAs crystals include the dopant Zn of high concentration. Fig.6 shows the state in which the InGaAs film grows to an enough thickness. Solid phase diffusion of Zn to the InP layer synchronizes with the growth of the InGaAs films. Zn diffuses from the InGaAs film to the InP window layer and the InGaAs receiving layer by heat.

The diffusion of Zn generates p-type regions in the InP window layer and the InGaAs receiving layer. In the example, the InP substrate concludes n-type carriers (electrons) of 5 × 10¹⁵cm⁻³. The Zn-doped InGaAs layer includes p-type carriers (holes) of 1.0 × 10¹⁹cm⁻³.

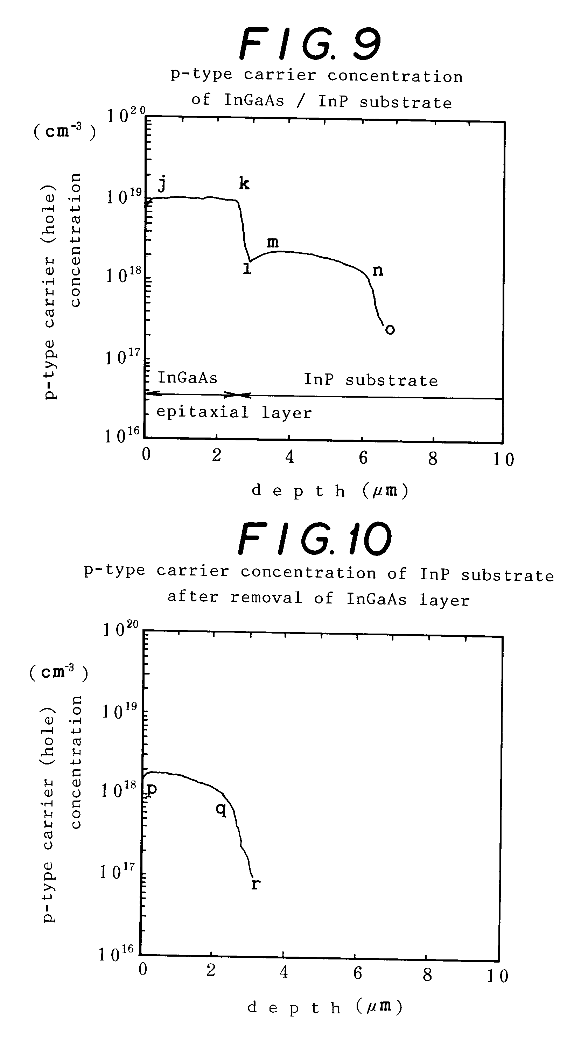

The solid phase diffusion carries Zn atoms from the Zn-doped InGaAs films into the InP window layer and InGaAs light receiving layer by heat. After the solid phase diffusion has ended, the distribution of Zn in the direction of the thickness is measured. Fig.9 shows the result of the measurement of the vertical distribution of the impurity. In Fig.9, the abscissa is the depth from the surface of the impurity-containing film (Zn-doped InGaAs film) in unit of µm. In the example, the thickness of the Zn-doped InGaAs is about 2.5 µm. The part deeper than 2.5 µm is the InP window layer and the InGaAs receiving layer. The ordinate is the concentration of the p-type carriers (holes).

In Fig.9, the range between j and k corresponds to the impurity-containing film (Zn-doped InGaAs film). The film part has a high hole concentration of 1 × 10¹⁹cm⁻³ which is nearly equal to the initial hole concentration. The concentration of holes is nearly equal to the concentration of Zn in the crystals. Although Zn atoms decrease in the film by the solid phase diffusion, the proportion of the diffused Zn atoms is small enough for the total amount of doped Zn atoms in the film. The p-type carrier concentration suddenly falls between k and 1. The part from k to 1 is the boundary between the InGaAs crystal and the InP layer. Zn atoms mainly in the range k-1 diffuse into the InP layer. The succeeding part from 1 to n corresponds to the InP window layer and the InGaAs light receiving layer on the wafer. In the part 1-m-n, the concentration of p-type carriers is nearly constant and is about 1 × 10¹⁸cm⁻³ to 2 × 10¹⁸cm⁻³. The hole concentration again falls from n to o. The range between n and o is far distanced from the Zn-doped InGaAs film. Therefore, few Zn atoms attain the range. The succeeding part deeper than n-o becomes the depletion layer (i-type).

Then the impurity-containing InGaAs film is eliminated from the InP window layer by etching with an etchant which removes only InGaAs but leaves InP intact. For example, a mixture of phosphoric acid (H₃PO₄) and hydrogen peroxide (H₂O₂) is adopted as an etchant for eliminating only the InGaAs film, leaving the InP crystal unimpaired.

The concentration of p-type impurity (hole) of the sample is measured. Fig.10 is the graph showing the result. The abscissa is the distance from the top surface of InP window layer. The ordinate is the hole concentration. The upper part from p to q (about 0 µm to 2 µm) has a stable p-type carrier concentration between 1 × 10¹⁸cm⁻³ and 2 × 10¹⁸cm⁻³. In the deeper part from q to r, the hole concentration drops conspicuously. At a 3 µm deep point, the p-carrier (hole) concentration is only 1 × 10¹⁷cm⁻³. The curve of the p-type carrier concentration signifies the formation of the p-type region on the surface of the InP wafer.

Photodetectors as shown in Fig.3 are fabricated by the diffusion method of this invention which belongs to the open tube methods. Then dark current, sensitivity and response property of the photodetectors are measured. The photodetectors made by this invention turn out to have the equivalent properties about the dark current, sensitivity and response to the photodetectors which are made by the closed tube diffusion method. The device made by this invention is not inferior in the physical properties to the device produced by the closed tube diffusion which can not treat wide wafers. This invention excels in the productivity, because the open tube method can easily treat large size wafers.

## Claims

1. A method of producing a semiconductor device comprising the steps of:
growing a suppression mask film having windows on a surface of a first-conductive type substrate,
growing impurity-containing films having impurities of a second-conductive type on the windows not covered with the suppression mask film of the substrate,
diffusing the impurities from the impurity-containing films to the substrate across a film-substrate interface in solid phase simultaneously with the growth of the impurity-containing films,
producing second-conductive regions partially in the first-conductive substrate, and
eliminating the impurity-containing films from the substrate selectively.

2. A method of producing a semiconductor device comprising the steps of:
growing a suppression mask film having windows on a surface of a first-conductive type substrate,
growing impurity-containing films having impurities of a second-conductive type on the windows not covered with the suppression mask film of the substrate,
diffusing the impurities from the impurity-containing films to the substrate in solid phase following the growth of the impurity-containing films,
producing second-conductive regions partially in the first-conductive substrate, and
eliminating the impurity-containing films from the substrate selectively.

3. A method as claimed in claim 1 or 2, wherein the impurity-containing films are constituted by three or four elements selected from In, Ga, As and P, and impurities of a second-conductive type.

4. A method as claimed in claim 1, 2 or 3, wherein the substrate is an n-type semiconductor and the impurity of the impurity-containing films is Zn, Mg or Cd.

5. A method as claimed in claim 3, wherein the impurity-containing films are grown on the windows by supplying a gas including chloride of P or As and hydrogen gas in a reaction tube having melted metal Ga or melted metal In and melted impurity at a higher temperature and the substrate wafer at a lower temperature.

6. A method as claimed in claim 3, wherein the impurity-containing films are grown on the windows by supplying a gas including hydride of P or As and hydrogen gas in a reaction tube having melted metal Ga or melted metal In and melted impurity at a higher temperature and the substrate wafer at a lower temperature.

7. A method as claimed in claim 3, wherein the impurity-containing films are grown on the windows by supplying a gas including hydride of P or As, metallorganic gases of In and Ga and hydrogen gas in a reaction tube having the substrate wafer.

8. A method of inspecting a semiconductor device comprising the steps of:
growing a suppression mask film having windows on a surface of a first-conductive type substrate,
growing impurity-containing films having second-conductive type impurities on the windows not covered with the suppression mask film of the substrate,
diffusing the second-conductive type impurities from the impurity-containing films to the substrate in solid phase simultaneously with the growth of the impurity containing films,
producing the second-conductive regions partially in the first-conductive substrate, and
observing the impurity containing crystals growing on holes of the suppression mask film or defects in the substrate by a microscope, and
judging the quality of devices before individual device chips are scribed and separated from the substrate wafer.

9. A method as claimed in claim 8, further comprising the steps of:
image-processing the image of the substrate wafer observed by the microscope,
comparing the images of individual devices with an image of a standard device,
finding differences between the object individual devices and the standard device, before
judging the quality of devices before the substrate is scribed and divided into device chips.
